# EUROPEAN PATENT SPECIFICATION

(11) **EP 3 711 158 B1**
(45) Date of publication and mention of the grant of the patent: **26.10.2022**
(21) Application number: 18811651.1
(22) Date of filing: 07.11.2018
(51) Int. Cl.: H02S 20/20, B60P 1/00

(54) **QUICK LOCKING DEVICE FOR CONNECTING PHOTOVOLTAIC SOLAR PANELS TO A SUPPORT STRUCTURE**
SCHNELLVERSCHLUSSVORRICHTUNG ZUM VERBINDEN VON FOTOVOLTAISCHEN SOLARPANEELEN MIT EINER TRAGSTRUKTUR
DISPOSITIF DE VERROUILLAGE RAPIDE DE CONNEXION DE PANNEAUX SOLAIRES PHOTOVOLTAÏQUES À UNE STRUCTURE DE SUPPORT

(30) Priority: 14.11.2017 IT 201700130000
(43) Date of publication of application: 23.09.2020
(73) Proprietor: Enel Green Power S.p.A., 00198 Roma (IT)
(72) Inventor: DI STEFANO, Giovanni, 10095 Grugliasco (Torino) (IT); BECCARISI, Francesco, 10095 Grugliasco (Torino) (IT); STERPILLA, Diego, 29122 Piacenza (PC) (IT); STRAZZA, Alfonso, 00124 Roma (IT)
(74) Representative: Romano, Giuseppe
(86) International application number: PCT/IB2018/058731
(87) International publication number: WO 2019/097359

(56) References cited:
- US-A- 5 768 831
- US-A1- 2013 240 008
- US-A1- 2013 284 239
- US-B1- 8 567 134

## Description

### Field of the invention

The present invention relates to a device for installing photovoltaic solar panels on a support structure arranged in an open space.

### Object of the invention

The object of the present invention is to propose an installation device for photovoltaic solar panels which makes the installation procedure easier and quicker than prior art.

An additional object of the invention is to propose a device for installing photovoltaic solar panels which guarantees a high reliability of the connection of the photovoltaic solar panels to the support structure thereof. An additional object of the invention is to implement a device for installing photovoltaic solar panels which guarantees a high safety against the risk of damaging the photovoltaic solar panels during the installing procedure. Still a further object of the invention is to propose an installation device which makes the installing procedure easy and quick even in case it is performed manually.

US8567134 discloses a photovoltaic assembly for converting solar radiation to electrical energy, wherein the photovoltaic assembly includes a first photovoltaic module, a second photovoltaic module and a coupling platform. The first and second photovoltaic module each have a first side for securing to the coupling platform. The coupling platform has a retractable locking mechanism and a retaining device. The retaining device is positioned such that the first side of the second PV module inhibits the retractable locking mechanism from releasing the first side of the first PV module. The coupling platform also includes a support member for mounting to a tracking drive system or a roof top.

US2013240008 discloses a photovoltaic module mounting system including a spacer pad, an adhesive material on a first side of the spacer pad, and a first engaging element on a second side of the spacer pad. The spacer pad is configured to be adhered to a photovoltaic module by the adhesive on the first side, and the first engaging element is configured to engage with a second engaging element of a support structure. US5768831 discloses a roof tile/roof slate/wall plate made of a plate of clay, ceramic, concrete, fiber cement or synthetic, serving as a carrier for a solar panel with photovoltaic solar cells to be attached to its upper side where said solar panel is attached form-fittingly to the upper side of the roof tile/roof slate/wall plate with at least two sides opposite to one another at the inner edges of a recess of a roof tile/roof slate/wall plate indent, and where the extensions, due to their own flexibility, are engaged in a snap-in manner particularly form-fittingly in recesses of the roof tile/roof slate/wall plate indentation.

US2013284239 discloses a solar cell module includes a solar cell panel including at least one solar cell; and a frame positioned at a periphery of the solar cell panel. The frame includes an align mark for alignment. An apparatus for generating photovoltaic power includes a solar cell module including a solar cell panel including at least one solar cell and a frame positioned at a periphery of the solar cell panel; and a supporter where the solar cell module is fixed by a fixer. The frame includes an align mark to align the solar cell module with at least one of the supporter and the fixer.

### Summary of the invention

In view of implementing one or more of the above-mentioned objects, the invention relates to an automatic quick locking device for installing at least a photovoltaic solar panel on a support structure, wherein the device is arranged on the support structure and the photovoltaic solar panel is installed on the support structure by approaching it to the support structure until reaching a final position wherein the locking device blocks automatically the photovoltaic solar panel on the support structure.

The quick locking device of the invention is defined by the subject-matter of claim 1.

In the present description, and in the following claims, under the expression "support structure" of the photovoltaic solar panel any structure is meant arranged on the ground intended to receive and support the photovoltaic solar panel. Typically, such structure is constituted by the mobile portion of a tracker of any known type, which is capable to orient the photovoltaic solar panel during the day so as to track the apparent motion of the sun.

According to an additional preferred feature, the device according to the invention is further characterized by the fact of comprising:
- mutual engagement elements carried by the photovoltaic solar panel and by the support structure, for centering the photovoltaic solar panel on the support structure, and
- at least a blocking element carried by one between said support structure and said panel, configured to shift automatically in a blocking position, wherein it blocks the other one between said support structure and said panel, when the photovoltaic solar panel reaches its final position.

According to an additional feature, the photovoltaic solar panel is provided with a respective frame, and said locking device is configured to block said frame of the photovoltaic solar panel on the support structure. In such embodiment, the above-mentioned mutual engagement elements are carried by the frame of the photovoltaic solar panel and by the support structure and they comprise an opening formed in one between said frame and said support structure and a preferably conical reference pin, carried by the other one between said frame and said support structure and apt to be received within the above-mentioned opening in the final position of the photovoltaic solar panel on the support structure.

### Brief description of the figures

Additional features and advantages of the invention will result from the following description with reference to the enclosed drawings, provided by pure way of not limitative example, wherein:
- figure 1 is a section view of a photovoltaic solar panel under the condition assembled on a support structure arranged in an open space, according to a solution of prior art,
- figure 2 illustrates in enlarged scale a detail of figure 1,
- figures 3, 4 are a section view and a perspective view of a first embodiment not part of the invention of a quick locking device of the photovoltaic solar panel,
- figures 5, 6 are schematic section views illustrating a second embodiment not part of the invention of the quick locking device, under the inoperative condition and under the blocking operative condition,
- figure 7 is a perspective view of the device of figures 5, 6,
- figure 8 is a perspective view of a third embodiment of a quick locking device not part of the invention,
- figures 9, 10 are schematic section views illustrating the quick locking device of figure 8, under the inoperative condition and under the blocking operative condition,
- figures 11A1 and 11A2 are a side view and a front view of a fourth embodiment of the quick locking device not part of the invention,
- figures 11B and 11C are perspective views of a fifth and a sixth embodiment of the quick locking device not part of the invention,
- figure 12 is a perspective view of a seventh embodiment of the quick locking device of the invention,
- figure 13 is a perspective view of the device of figure 12 assembled on a support structure,
- figures 14A and 14B are a top plan view and a side view of the device of figure 12, respectively
- figures 15A, 15B and 15C illustrate, in sequence, a locking phase of a photovoltaic panel on a device of figure 12,
- figure 16 illustrates a further possible locking phase of a photovoltaic panel on a device of figure 12,
- figure 17 illustrates the locking of two photovoltaic panels on a same device of figure 12,
- figure 18 illustrates a portion of support structure arranged to receive the photovoltaic solar panels, and
- figure 19 shows a possible assembly configuration of a plurality of devices according to the seventh embodiment on a support structure.

### Detailed description of embodiments of the invention

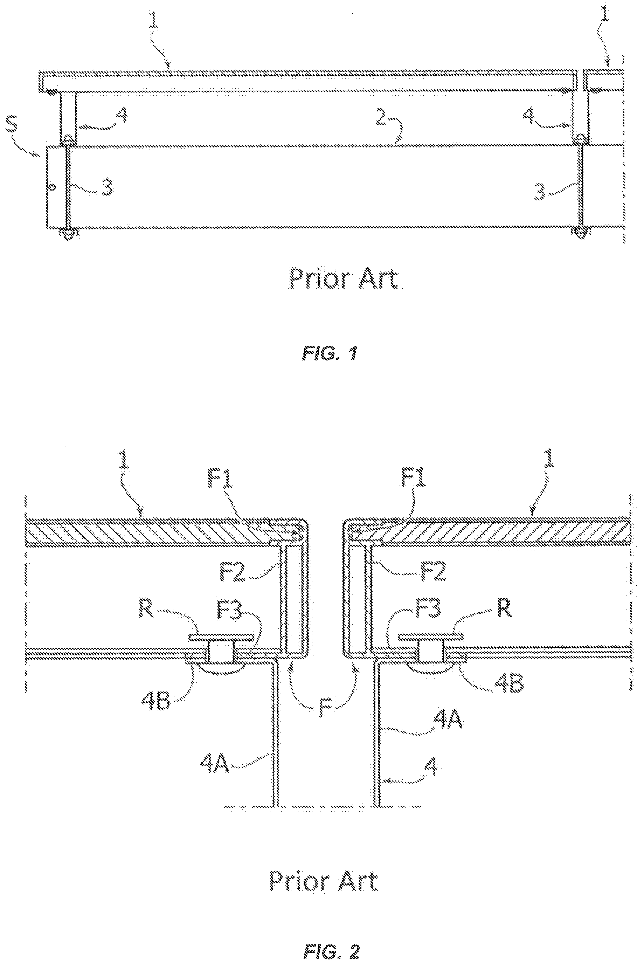

Figures 1, 2 show an example for connecting several photovoltaic solar panels to a support structure arranged on an open space, according to prior art.

As already above indicated, in the present description and in the following claims, under the expression "support structure" of the photovoltaic solar panel any structure is meant arranged for such purpose in an open ground. Typically, such structure is constituted by the mobile portion of a tracker, implemented in any known way, intended to make the photovoltaic solar panels to swing during the day, so as to track the apparent motion of the sun.

In figures 1, 2, the reference number 1 designates two photovoltaic solar panels (one thereof is illustrated only partially in figure 1) belonging to a series of photovoltaic solar panels arranged in an open space. According to the most common solution, the photovoltaic solar panels are arranged in several rows parallel therebetween and spaced apart above the respective support structures.

In case of the known example illustrated in figure 1, the support structure of the photovoltaic solar panels 1, designated as a whole with S, includes a beam 2, thereon profiles 4 with overturned omega-like section are connected stiffly by means of bolts 3. All above-mentioned elements are made of metal material, for example steel. Figure 2 shows the upper portion of a profile 4. Each profile 4 has two parallel and spaced-apart walls 4A which have their upper longitudinal edges bent at 90° towards outside, so as to define two flanges 4B.

Each photovoltaic solar panel 1 has a structure of any known type having a quadrilateral configuration. Along its four sides, each photovoltaic solar panel 1 is carried by a peripheral frame F, for example made of plastic material. The present invention, however, does not exclude that the solar panel could have no frame, in which case the panel itself couples with the support structure.

As it can be seen in figure 2, the frame F has a cross section with an upper portion defining a seat F1 for receiving a respective edge of the photovoltaic solar panel 1 and a vertical wall F2 extending towards the bottom from the upper portion. An additional wall F3 extends at the lower end of the vertical wall F2, which additional wall results to be parallel and spaced apart by the photovoltaic solar panel 1 and acts as flange for the connection to a respective flange 4B of a respective profile 4.

According to prior art, the frames F of the photovoltaic solar panels 1 are connected to the flanges 4B of the profiles 4 by means of rivets or nails R (see figure 2) or alternatively by means of any other connecting means.

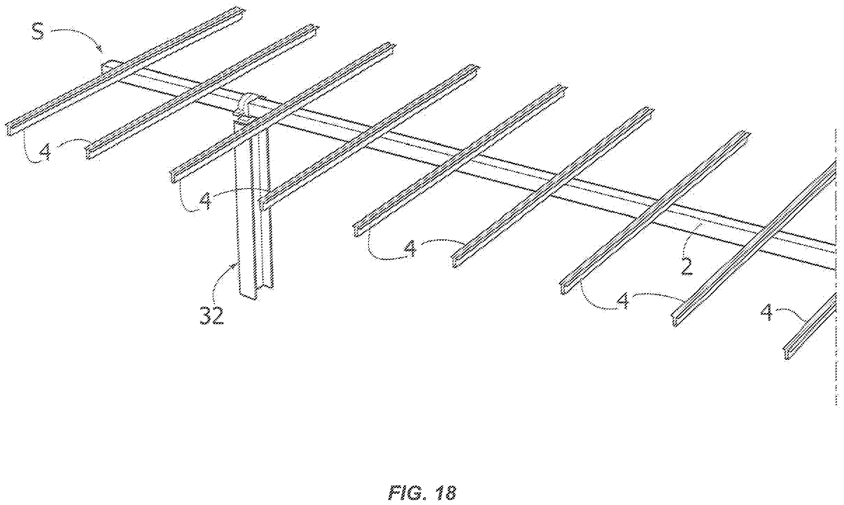

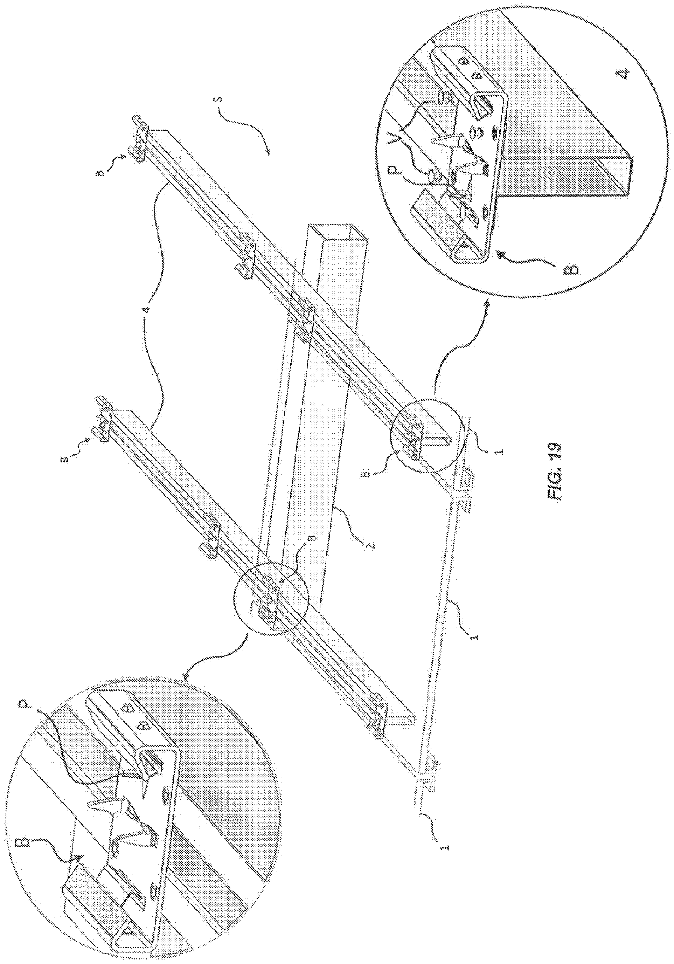

An example of the support structure S, with the beam 2 and the profiles 4, can also be seen in figures 18 and 19, which will be illustrated hereinafter, relatively to an embodiment of the device according to the invention. Such figures show even that the structure S comprises supporting uprights 32, driven in the ground (only one thereof is visible in figure), which carry the beam by means of joining devices, of any known type, including means for making the beam 2 to swing around its longitudinal axis, with the purpose of obtaining the solar tracking motion of the photovoltaic solar panels intended to be carried by the structure S.

As it results clear, the connecting system used in the known solution illustrated in figures 1 and 2 involves relatively difficult and long installation procedures.

The present invention is capable to obviate such drawbacks, thanks to the fact that it provides, on the support structure S and/or the supporting frame F of the photovoltaic solar panel 1, a quick locking device configured so as to implement the connection of the frame of the photovoltaic solar panel to the support structure after a lowering motion from the top of the photovoltaic solar panel 1 on the support structure S, until reaching a final position of the panel 1 wherein the locking device blocks automatically the frame F of the photovoltaic solar panel 1 on the support structure S.

With the purpose of implementing the present invention, the support structure S and the supporting frame F of each photovoltaic solar panel 1 can have for example the same configuration illustrated in figures 1, 2 with reference to the known solution. However, in case of the invention, the connection between the flanges F3 of the frame F of the panel 1 and the flanges 4B of the stirrups 4 of the support structure S is obtained, instead of applying connecting means such as rivets R, by means of a quick locking device,

From the figures, the description thereof follows, it is clear that the above mentioned lowering motion from the top, thereto the panel is subjected until reaching a final position wherein the locking device B blocks automatically, involves a motion of the panel, at least near the device B, only according a rectilinear trajectory along a direction orthogonal to a supporting plane of the panel itself defined by the device e/o by the support structure S, which keeps it parallel to the supporting plane. In the context of this description, the term "rectilinear trajectory" wishes to designate a "mainly rectilinear" trajectory, that is "overall rectilinear" unless shiftings with very reduced width with respect to the overall shifting and due, for example, to the discretization of the trajectory itself. In other words, translation motions of the panel along other directions, rotation motions of the same and even combined motions are neither provided nor required.

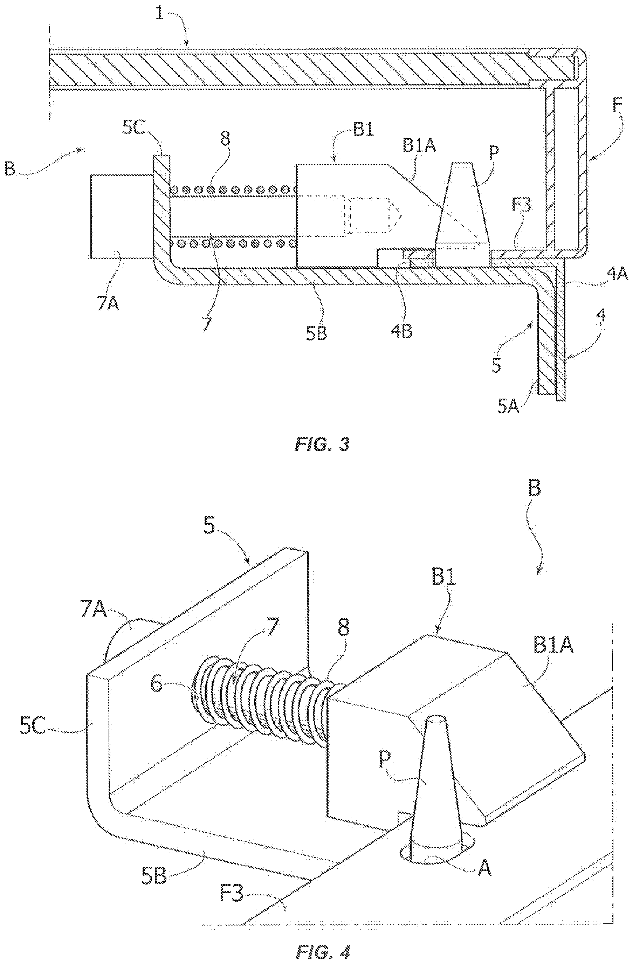

Figures 3, 4 show a first embodiment of a quick locking device B . As it can be seen in such figures, an additional stirrup 5 with S-like profile is connected, for example by welding or screwing, to one of the walls 4A of a profile 4, such stirrup having a vertical flange 5A anchored to the respective wall 4A of the profile 4, a substantially horizontal wall 5B and an end vertical flange 5C, situated on the opposite side with respect to the flange 5A.

In the end flange 5C a hole 6 is formed wherein a stem 7, carrying a blocking element B1, is slidably assembled. Around the stem 7 a helical spring 8 is assembled which is interposed between the blocking element B1 and the end flange 5C and which tends to keep the blocking element B1 in a blocking operative position, defined by the engagement of a head 7A of the stem 7 against the outer surface of the end flange 5C.

Under the assembled condition of the photovoltaic solar panel, the blocking element B1 is overlapped to the upper surface of the frame F of the panel 1 so as to block the frame F, with respect to the vertical motions, against the upper surface of the flange 4B of the profile 4.

Still with reference to figures 3, 4, the motions of the frame F of the panel 1 in the horizontal plane are prevented by the engagement of reference pins P, preferably having conical shape (one thereof is visible in the drawings), extending upwards starting from the wall 5B, and crossing openings arranged in the flange 4B of the profile 4 as well as slots A formed in the flange F3 of the frame F. Some slots A (such as the one illustrated in the drawings) extend in the direction of the length of the corresponding side of the panel 1, whereas others extend in a transverse direction with respect thereto.

As it can be seen in figures 3, 4, the blocking element B1 has a wedge-like tilted front surface B1A, having cam function, so that the photovoltaic solar panel can be installed by lowering it from top above the profiles 4 until obtaining an engagement of the flanges F3 of the frame F of the panel against the wedge-like tilted surface B1A of the blocking element B1. As a result of the tilted configuration of the surface B1A, the lowering motion of the photovoltaic solar panel 1 determines a back motion of the blocking element B1, against the action of the spring 8, until the moment in which the flange F3, having reached its final position in contact with the flanges 4B, is blocked by the blocking element B which snaps forward thereabove due to the spring 8. During the lowering motion of the photovoltaic solar panel 1 above the profile 4, the conical reference pin P engages the opening A of the flange F3, so as to meet the centering function which guarantees that the panel reaches a correct position along the two directions of a horizontal plane.

As it can be seen, then, the disclosure allows to obtain in a simple, easy and quick way, the blocking of the frame F of each photovoltaic solar panel 1 above the support structure S.

Of course, the construction details of the embodiment which is illustrated in figures 3, 4 can vary widely. This is applied both to the configuration of the blocking element B1, as to the way therewith the motion of the blocking element B1 between its inoperative position and its operative position is guided, and even with reference to the configuration and to the arrangement of the elastic means recalling the blocking element B1 towards the blocking operative position. The same is valid for the configuration of the reference pin P and of the opening A receiving it. Generally, what it is necessary to provide is that the support frame F of the photovoltaic solar panel 1 and the support structure S are arranged with mutual engagement elements to meet the centering function of the panel in the horizontal plane. Even as far as the quick locking device B is concerned, nothing automatically excludes that the blocking element B1 could be carried by the frame F of the photovoltaic solar panel and is apt to engage the support structure S under the final installed condition of the panel 1.

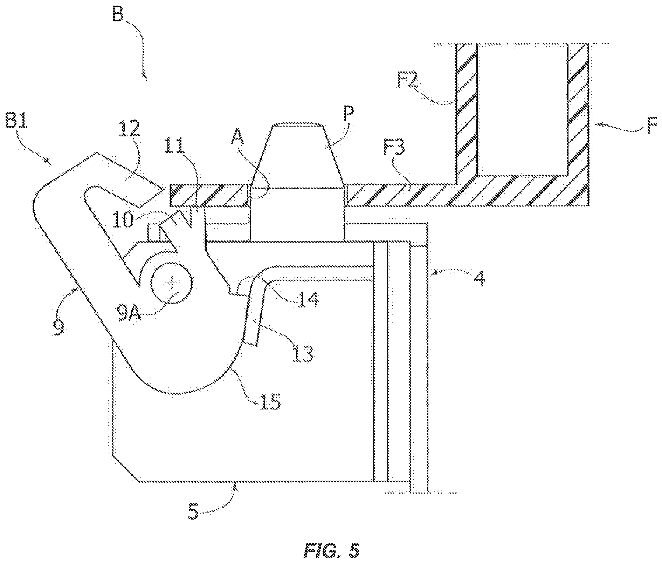

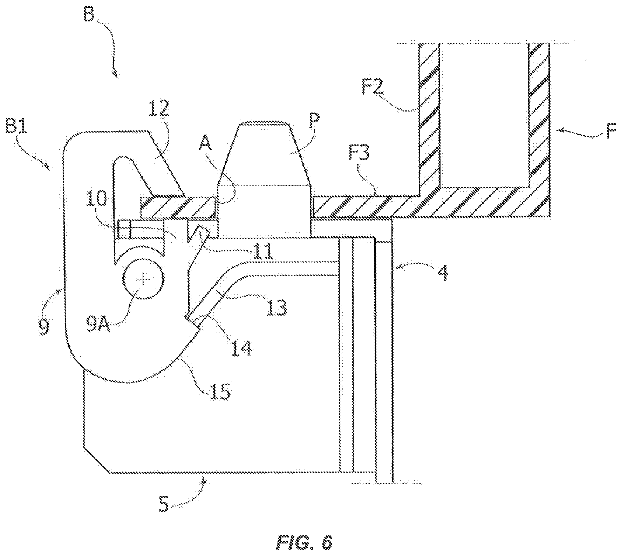

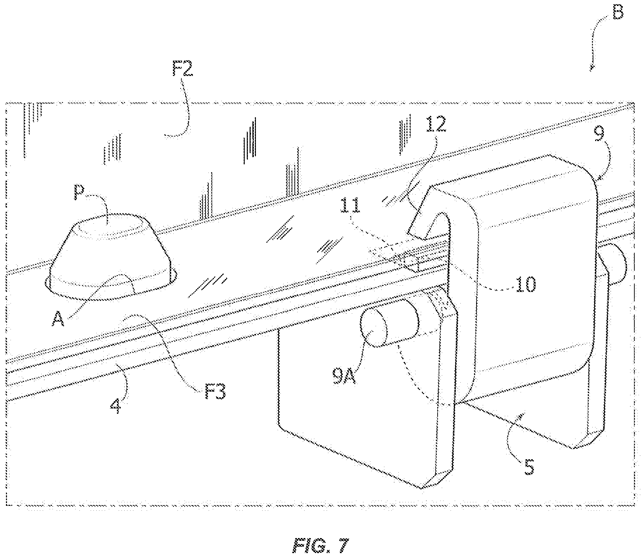

Figures 5, 6 and 7 illustrate a second embodiment providing, analogously to the one of figures 3, 4, mutual engagement elements for centering the panel 1 in the horizontal plane, including one or more preferably conical or however tapered reference pins P, projecting upwards by a supporting stirrup 5 fastened to the wall 4A of the respective profile 4 and one or more slots A formed in the flange F3 of the frame F of the photovoltaic solar panel for engaging the pins P. In the example illustrated in figure 7 a pin P has a base section with elongated shape, so as to engage the whole length of the slot A and to refer the panel 1 in two horizontal directions orthogonal therebetween. In this case the quick locking device B comprises a blocking element B1 constituted by an element 9, for example made of metal material and for example obtained by extrusion, which is assembled so as to revolve around a pin 9A (figure 7) on the supporting stirrup 5. The element 9 has a portion 10 with a matching surface 11. The surface 11 is engaged by the lower flange F3 of the frame F of the panel during the lowering motion of the panel so as to cause a rotation of the blocking element B1 from the inoperative position illustrated in figure 5, to the blocking operative position illustrated in figure 6, wherein an upper lip 12 of the blocking element B1 engages the upper surface of the flange F3 by blocking it against the flange 4B and thus preventing any motion of the panel 1 in the vertical direction. Under such blocking condition, the blocking element B1 is kept by a stopping element constituted by an elastic sheet 13, carried by the stirrup 5 and apt to engage a seat 14 of the element 9. As it can be seen in figure 5, in the inoperative position of the blocking element B1, the stopping element 13 is outside the engagement in the seat 14 and it is kept under a condition elastically deformed from the engagement against the outer surface 15 of the element 9.

Of course, even with reference to the embodiment illustrated in figures 5, 6 and 7, the considerations developed above about the embodiment of figures 3, 4 are valid, relatively to the possible variants of the mutual engagement elements which guarantee the centering of the photovoltaic solar panel in the horizontal plane, and relatively to the possible configuration variants of the blocking element B1, and of the configuration and arrangement of the elastic elements which keep the blocking element B1 in the blocking operative position.

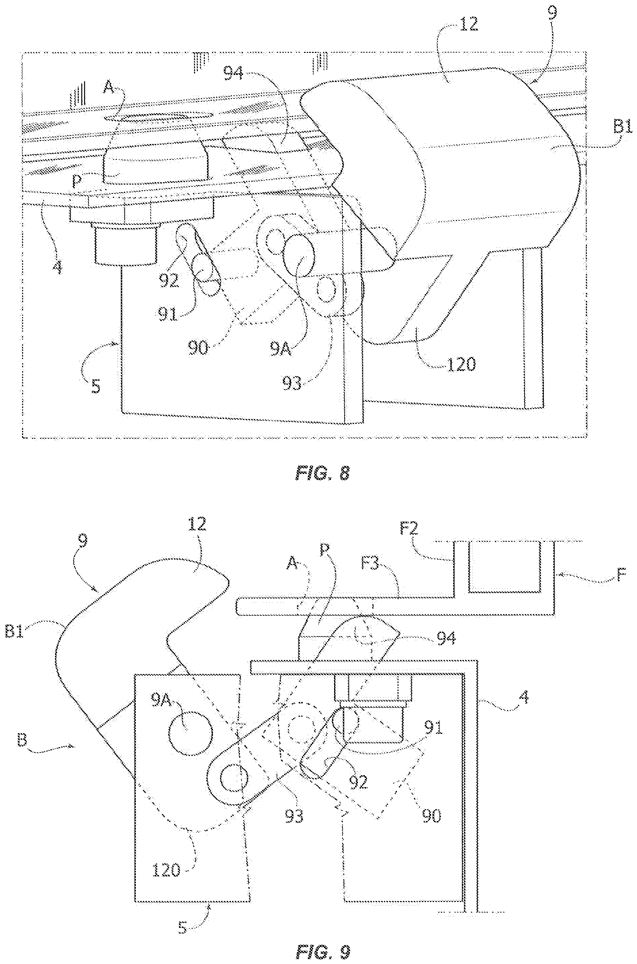

Figures 8-10 illustrate an additional embodiment wherein the mutual engagement centering elements (pins P and slots A) can remain the same of figures 3, 4 or figures 5-7, whereas the blocking element is implemented in a different way. In this case, the blocking element B1 is jointed by means of a pin 9 to the stirrup 5, so as to be able to swing from an inoperative position (illustrated in figure 8) to a blocking operative position, wherein a front mouth thereof 12 overlaps to the flange F3 of the photovoltaic solar panel 1. The rotation of the blocking element B1 is induced by toggle levers, including a rod 93, which is connected in jointed way at its ends to the element B1 and to a lever 90. The lever 90 carries a pin 91 which can swing and slide within a slot 92 of the stirrup 5. Under the inoperative condition of the blocking element B1, the lever 90 has a portion 94 projecting upwards with respect to the resting plane of the photovoltaic solar panel on the profiles 4. When the panel 1 is lowered above the profiles 4, it pushes downwards the portion 94 of the lever 90. The lever 90 is then obliged to rotate around the axis of its own pin 91 so as to cause, by means of the rod 93 the rotation of the element B1 in the blocking position.

Such rotation takes place until the dead end is overcome wherein the axis of the pin 91 and the axes of the end joints of the rod 93 are aligned, therefore the blocking element B1 remains blocked in such position.

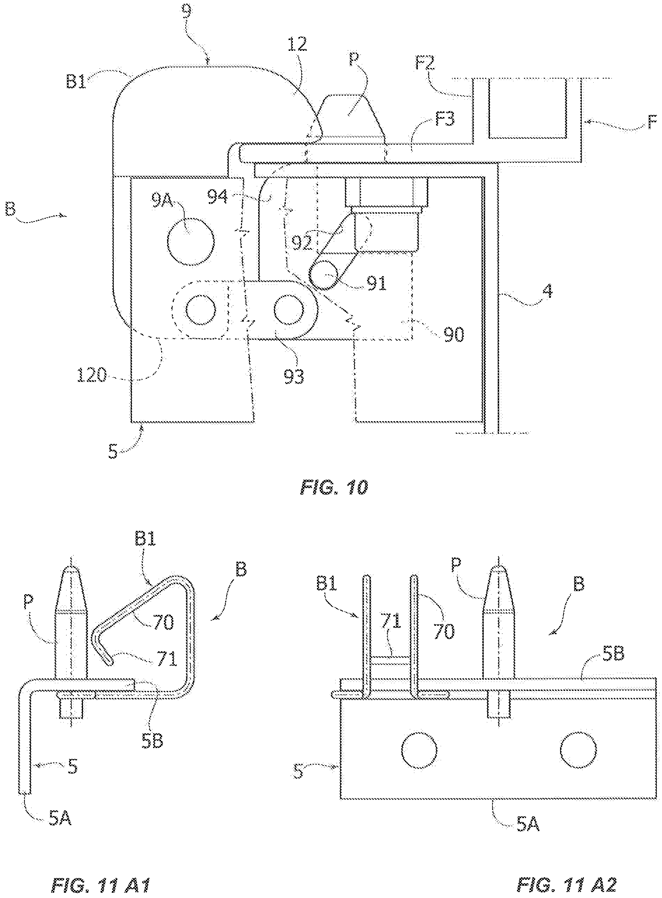

Figures 11A1 and 11A2 illustrate a side view and a front view of an additional embodiment, wherein the quick locking device B comprises mutual engagement centering elements in form of a pin P and a slot A (the slot not visible in these figures) identical to those of figures 3, 4 or figures 5-7, and a blocking element B1 in form of a U-like bent metal tendon, with a base portion anchored to a flange 5B of a stirrup 5 fastened to the (not illustrated) profile 4, an elastically deformable portion 70, apt to perform the cam function during the lowering motion of the panel 1, and a hook-like terminal portion 71 apt to overlap to the (not illustrated in such figures) flange F3, by blocking it above the flange 4B of the profile 4, when the panel 1 has reached its final position in contact with the flange 4B.

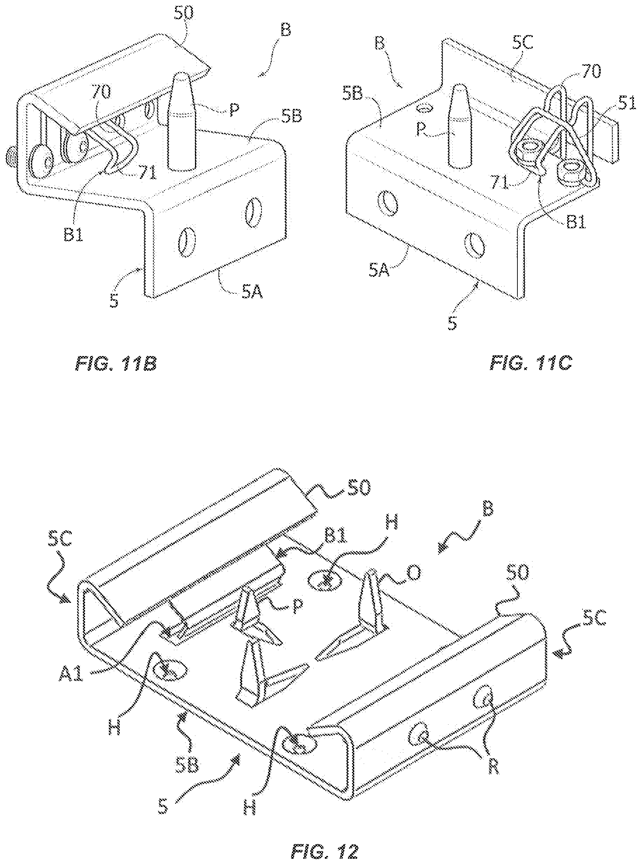

Figure 11B shows a variant wherein the blocking element B1 is partially covered by a flange 50 of the stirrup 5, which has the function of reinforcement with respect to possible deformations upwards of the portion 70 of the blocking element B1 when, after the connection with the panel 1, an action tending to raise the panel itself is exerted.

In all above-described embodiments, the plate 5 can also be obtained as one single piece with the profile 4.

Figure 11C shows an additional variant wherein a containment stirrup 51 is engaged above the root of the deformable portion 70, the stirrup being constituted by a U-like bent metal tendon, arranged like a bridge above the portion 70, with the ends fastened to the stirrup 5. Even in this case, the stirrup 51 has the function of reinforcement with respect to possible deformations upwards of the portion 70 of the blocking element B1 when, after the connection with the panel 1, an action tending to raise the panel itself is exerted.

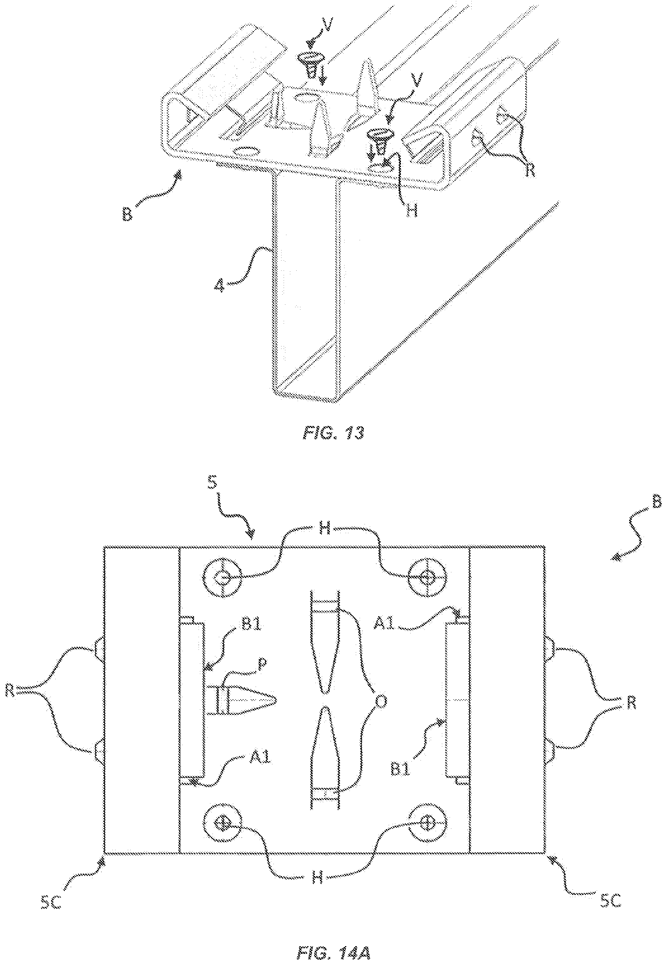

By referring now to figures 12 to 17, these show a seventh embodiment of a device according to the present invention.

In the following description of this seventh embodiment, the same note already used for the other embodiments will be used. Therefore, equal references will designate equal elements, both in strictly structural and functional meaning,

According to this embodiment, a quick locking device B comprises a stirrup 5 which could be fastened to the support structure S. In particular, the stirrup 5 provides a base flange 5B having fastening means H - for example holes for the positioning of screws, rivets or equivalent elements for the fastening to the support structure S.

The base flange 5B, preferably implemented as flat sheet, defines a supporting plane which receives the photovoltaic panels and has two opposite ends 5C folded on themselves, ending with respective reinforcing flanges 50 to form two substantially "C"-shaped seats faced therebetween.

Each reinforcing flange 50 forms an angle α with the extremal wall of the corresponding end 5C. Preferably the angle α is comprised between 45° and 75°. Still more preferably it is about 60°.

According to this embodiment, the device B comprises two blocking elements B1, one at each end 5C.

Each blocking element B1, in turn, comprises a respective sheet-like elastic element 70, 71 shaped so as to place within said "C"-like seats and having a terminal portion 71 at least partially projecting from the reinforcing flange 50.

The sheet-like elastic element is fastened to the stirrup 5, for example by means of rivets R. Of course, it is to be meant that other fastening modes could be provided.

The fact of providing a sheet-like elastic element allows to reduce the plastic deformations of the blocking element B1 which, over time, would cause a decrease in efficiency of the device.

Therefore, the quick locking device B according to such seventh embodiment, can house contemporarily two photovoltaic panels 1, by allowing the locking at the two opposite ends 5C. This simplifies greatly the installation process on the support structure S and allows to reduce the use of materials and to keep low the installation costs.

Advantageously, the quick locking device B according to this embodiment can further comprise one or more matching elements O, preferably arranged in central position on the base flange 5B.

These are used as housing guide for the photovoltaic panels 1 during installation.

Preferably, the matching elements O are implemented by means of a portion of base flange 5B partially cut and folded upwards.

Similarly, even one or more mutual engagement elements P can be provided, shaped so as to result apt to cooperate, during installation, with respective slots A implemented on the photovoltaic panels 1.

Preferably, according to this embodiment, each quick locking device B provides one single matching element P, implemented at one of the two ends 5C. The presence of the matching element P only on one side of the device can be advantageous in terms of assembly, as it will be described hereinafter. The solution can further provide two matching elements P, positioned in symmetrical position with respect to the centre of the base flange 5B, both of them implemented by means of a portion of base flange 5B partially cut and folded upwards.

Even the mutual engagement elements P can advantageously be implemented by means of a portion of base flange 5B partially cut and folded upwards.

Moreover, the base flange 5B advantageously can include two slots A1 implemented at the terminal portions 71, to allow the lowering thereof during the engagement with the photovoltaic solar panel 1.

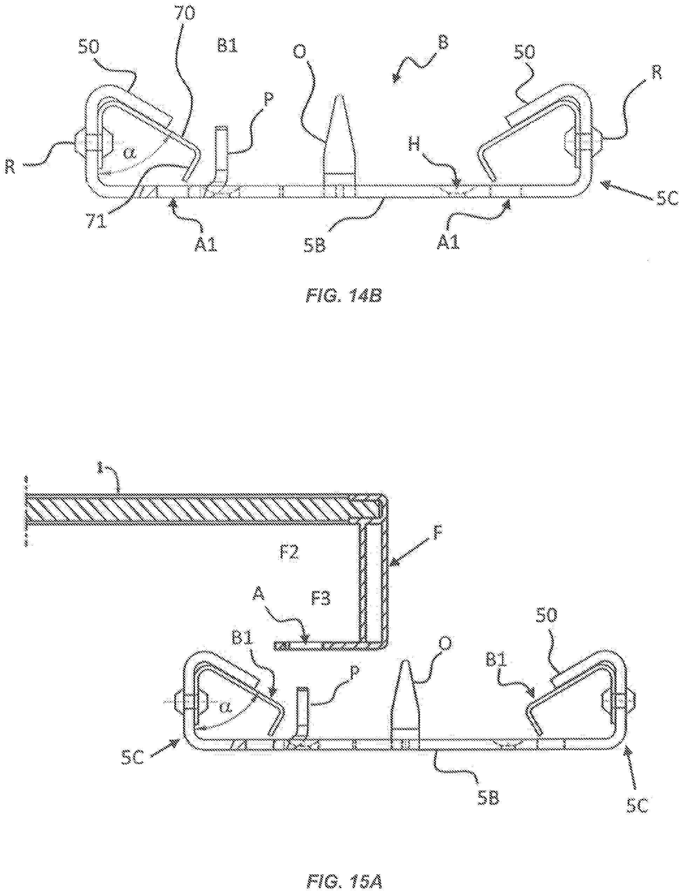

By making reference to figures 15A to 15C, the operating phase for installing a photovoltaic solar panel 1 on a support structure S will be described hereinafter, when the quick locking device B is the one according to the seventh embodiment of the present invention.

In particular, figure 15A shows a starting initial position, wherein the photovoltaic panel 1 is positioned above the quick locking device B, in substantially parallel position and with the peripheral portion of the frame F aligned with the matching element O.

Should the photovoltaic panel 1 be of the type having a centering slot A on the flange F3, a corresponding mutual engagement element P could advantageously be provided on the quick locking device B. Evidently, in case the panel 1 had no centering slots A, quick locking devices B without mutual engagement elements P could be used, the latter not being strictly required for the operation.

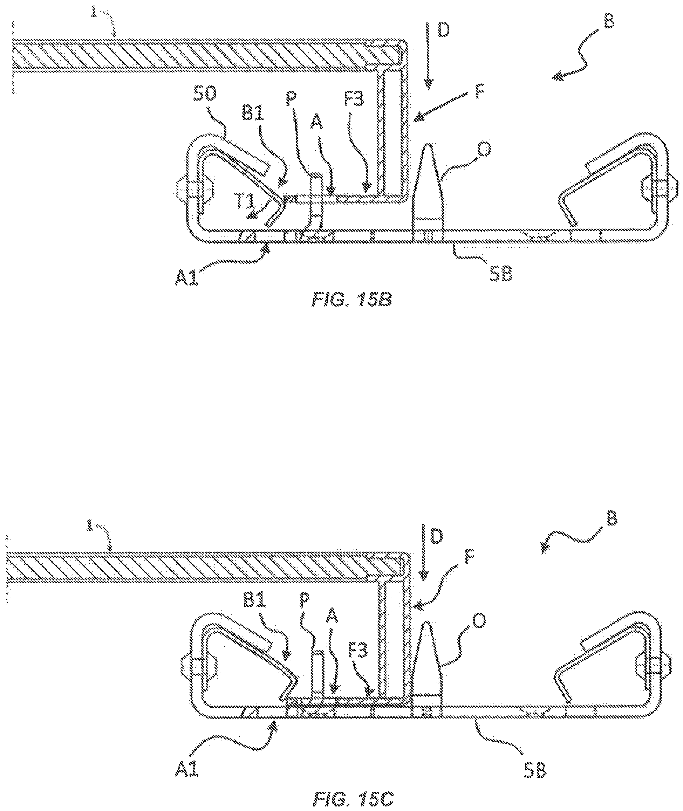

The use of a device according to the present invention provides to move the photovoltaic panel 1, by approaching it to the quick locking device B, only according to a rectilinear trajectory, according to a direction D orthogonal to the supporting plane defined by the flange 5B and which keeps it parallel to the flange 5b of the device B, as designated by the arrow D in figure 15B. In the contest of this description, the term "rectilinear trajectory" wishes to designate a "mainly rectilinear" trajectory, that is "overall rectilinear" unless shifting with much reduced width than the overall shifting and due, for example, to the discretization of the trajectory itself. In other words, translation motions of the panel along other directions, rotation motions of the same and combined motions, when the panel is in the immediate proximity of the blocking device B, are neither provided nor required.

During approaching the panel 1 to the device B, the flange F3 of the photovoltaic panel 1 will engage the elastic portion 70 of the blocking element B1.

Under the push of the photovoltaic panel 1, the elastic portion 70 will deform, by bending in the direction designated by the arrow T1 in figure 15B.

This behaviour continues until the end of the flange F3 of the panel exceeds the most extremal portion of the elastic portion 70. As already illustrated, during this phase, the terminal portion 71 of the blocking element B1, could advantageously even arrive even below the flange 5B, through the slot A1.

With reference to figure 15C, when the photovoltaic solar panel 1 reaches its final position in contact with the flange 5B, the blocking element B1 will tend to return to its original resting condition, at least as much as it is allowed it by the interference with the flange F3 of the panel itself. In fact, it is provided that the terminal portion 71 of the blocking element B1 engages the flange F3, by blocking it automatically in the final blocking position with the force required for keeping the photovoltaic panel 1 in contact with the structure S, under all operative conditions provided for the structure S.

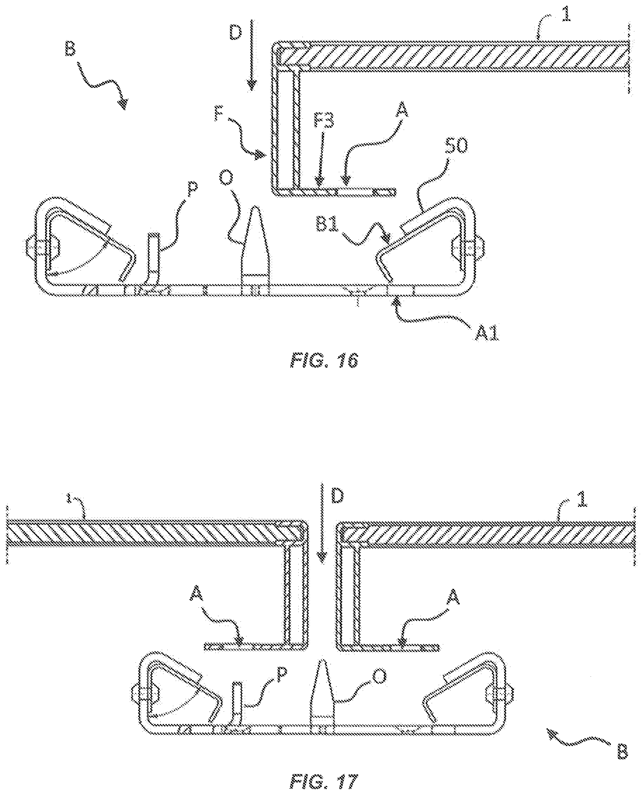

The subsequent figure 16 describes by way of example the same procedure for installing a photovoltaic panel 1, however performed at the opposite end of the locking device B.

In this case, the operation remains substantially identical. According to what illustrated, even if by way of example, the device does not provide on this side any mutual engagement element P, therefore no cooperation with the centering slots A in case present on the flange F3 of the photovoltaic panel 1 is provided.

The subsequent figure 17 shows the way in which a single quick locking device B according to such seventh embodiment could be used to receive contemporarily two photovoltaic panels 1, in specular and symmetrical position therebetween.

As already shown, an example of support structure S, with the beam 2 and the profiles 4, can also be seen in figures 18 and 19. Such figures further show that the structure S comprises supporting uprights 32, driven in the ground (only one thereof is visible in figure), which carry the beam by means of joining devices, of any known type, including means for making the beam 2 to swing around its longitudinal axis, with the purpose of obtaining the solar tracking motion of the photovoltaic solar panels intended to be carried by the structure S.

In particular, figure 19 shows, by way of example, the way in which the quick locking devices according to the present invention could be assembled thereon, and in the specific example of figure, those according to the now described seventh embodiment.

In this sense, as it can be easily seen in the two enlargements encircled in figure, the quick locking devices B are, as already described, so as each one to provide a single mutual engagement element P, on only one of the two sides intended to receive respective photovoltaic panels.

As illustrated, on the structure S, in particular on the beams 4, the quick locking devices B are assembled by alternating the orientation thereof, so as to have as a whole an alternation even in the position of the mutual engagement elements P.

This characteristic assembly mode advantageously allows to 'relax' the mechanical tolerances and the yokes during the approaching of the panels and then to allow an easier assembly of the same even should the alignments not be extremely precise.

In all above-described embodiments, preferably it is also provided that after blocking a photovoltaic solar panel on the support structure S, the blocking device B can be brought again in the inoperative position thereof, to remove the photovoltaic solar panel, for example to proceed with maintenance procedures or a replacement thereof. However, it. is not excluded a priori the case wherein the quick locking device is irreversible, that it does not allow the disassembling of the panel 1 anymore, once this has been locked, unless by destructing the connecting device.

The above-described device can be used, if it is preferred, to perform manually the procedure for installing the photovoltaic solar panels 1 on their support structure S. However, the device of the invention can also be used to perform the installation procedure automatically.

As it results evident from the preceding description, the device according to the invention reduces drastically the time required to perform the installation, it guarantees to obtain a high and uniform precision in positioning the photovoltaic solar panels 1 and it guarantees a correct blocking of the panels under the installed condition. The device according to the invention can also be used to perform manually the installation in simple and easy way for the operators.

The present invention has been sofar described with reference to preferred embodiments thereof. It is to be meant that each one of the technical solutions implemented in the preferred embodiments, herein described by way of example, can also be advantageously combined with the other ones, differently from what described, to produce further embodiments relating to the same inventive core and however all within the protective scope of the herebelow reported claims.

## Claims

1. A quick locking device (B) for connecting at least a photovoltaic solar panel (1) to a support structure (S), the device being configured so that said at least a photovoltaic solar panel (1) can be installed on the support structure (S) by approaching it to said support structure (S) with a lowering motion from the top only according to a rectilinear trajectory orthogonal to a support plane of said photovoltaic solar panel (1) defined by said locking device (B) until reaching a final position wherein said locking device (B) blocks automatically the photovoltaic solar panel (1) on the support structure (S), the quick locking device (B) comprising at least a blocking element (B1) configured to be able to shift automatically during installation from a released inoperative position to a blocking operative position after engagement thereon by said photovoltaic solar panel (1), when the photovoltaic solar panel (1) reaches its final position,
wherein the quick locking device (B) comprises a stirrup (5) having a base flange (5B) having fastening means (H) for the fastening to the support structure (S), said base flange (5B) having two folded opposite ends (5C), ending with respective reinforcing flanges (50) to form two substantially "C"-shaped faced seats,
the device being **characterized in that** it comprises
two blocking elements (B1), one at each end, each blocking element (B1) comprising a respective sheet-like elastic element (70, 71) shaped so as to be placed within said "C"-like seats and having a terminal portion (71) at least partially projecting from said reinforcing flange (50).

2. The quick locking device (B) according to claim 1, further comprising mutual engagement elements (P), configured to cooperate during installation with corresponding engagement elements (A) of the photovoltaic solar panel (1), for centering the photovoltaic solar panel (1) on the support structure (S).

3. The quick locking device (B) according to claim 2, wherein said mutual engagement elements comprise a reference pin (P), and said engagement elements (A) of the panel (1) comprise an opening (A), so that said reference pin (P) could be received in said opening (A) in the final position of the photovoltaic solar panel (1) on the support structure (S).

4. The quick locking device (B) according to one of claims 1 to 3, wherein said base flange (5B) comprises two slots (A1) implemented at said terminal portions (71), to allow the lowering thereof during the engagement with the photovoltaic solar panel (1).

5. The quick locking device (B) according to one of claim 1 to 4, further comprising one or more matching elements (O) arranged in central position on said base flange (5B), apt to provide a housing guide for the panels (1) during installation.

6. The quick locking device (B) according to claim 5, wherein said one or more matching elements (O) are implemented by means of a portion of base flange (5B) partially cut and folded upwards.

7. The quick locking device (B) according to one of claims 1 to 6, further comprising at least a mutual engagement element (P), apt to cooperate with a respective slot (A) implemented on the photovoltaic panel (1) during installation.

8. The quick locking device (B) according to claim 7, wherein said at least a mutual engagement element (P) is implemented by means of a portion of base flange (5B) partially cut and folded upwards.

## Patentansprüche

1. Schnellverschlussvorrichtung (B) zum Verbinden mindestens eines Photovoltaik-Solarpaneels (1) mit einer Tragstruktur (S), wobei die Vorrichtung so ausgestaltet ist, dass das mindestens eine Photovoltaik-Solarpaneel (1) auf der Tragstruktur (S) installiert werden kann, indem es sich der Tragstruktur (S) mit einer Absenkbewegung von oben nur gemäß einer geradlinigen Bahn orthogonal zu einer durch die Verschlussvorrichtung (B) definierten Tragebene des Photovoltaik-Solarpaneels (1) nähert, bis es eine Endposition erreicht, in der die Verschlussvorrichtung (B) das Photovoltaik-Solarpaneel (1) automatisch auf der Tragstruktur (S) blockiert, die Schnellverschlussvorrichtung (B) mindestens ein Blockierelement (B1) umfasst, das so ausgestaltet ist, dass es sich während der Installation automatisch von einer freigegebenen Ruheposition in eine blockierende Betriebsposition verschieben kann, nachdem das Photovoltaik-Solarpaneel (1) daran angreift, wenn das Photovoltaik-Solarpaneel (1) seine endgültige Position erreicht,
wobei die Schnellverschlussvorrichtung (B) einen Bügel (5) mit einem Basisflansch (5B) umfasst, der Befestigungsmittel (H) für die Befestigung an der Tragstruktur (S) aufweist, wobei der Basisflansch (5B) zwei gegenüberliegende umgebogene Enden (5C) hat, die mit jeweiligen Verstärkungsflanschen (50) enden, um zwei im Wesentlichen "C"-förmige gegenüberliegende Sitze zu bilden,
wobei die Vorrichtung **dadurch gekennzeichnet ist, dass** sie zwei Blockierelemente (B1) umfasst, eines an jedem Ende, wobei jedes Blockierelement (B1) ein jeweiliges folienartiges elastisches Element (70, 71) umfasst, das so geformt ist, dass es innerhalb der "C"-artigen Sitze platziert werden kann, und einen Endabschnitt (71) aufweist, der zumindest teilweise von dem Verstärkungsflansch (50) vorsteht.

2. Schnellverschlussvorrichtung (B) nach Anspruch 1 ferner umfassend gegenseitige Eingriffselemente (P), die so ausgestaltet sind, dass sie während der Installation mit entsprechenden Eingriffselementen (A) des Photovoltaik-Solarpaneels (1) zusammenwirken, um das Photovoltaik-Solarpaneel (1) auf der Trägerstruktur (S) zu zentrieren.

3. Schnellverschlussvorrichtung (B) nach Anspruch 2, wobei die gegenseitigen Eingriffselemente einen Referenzzapfen (P) umfassen und die Eingriffselemente (A) des Paneels (1) eine Öffnung (A) umfassen, so dass der Referenzzapfen (P) in der endgültigen Position des Photovoltaik-Solarpaneels (1) auf der Tragstruktur (S) in der Öffnung (A) aufgenommen werden kann.

4. Schnellverschlussvorrichtung (B) nach einem der Ansprüche 1 bis 3, wobei der Basisflansch (5B) zwei Schlitze (A1) umfasst, die an den Endabschnitten (71) ausgebildet sind, um das Absenken derselben während des Eingreifens mit dem Photovoltaik-Solarpaneel (1) zu ermöglichen.

5. Schnellverschlussvorrichtung (B) nach einem der Ansprüche 1 bis 4, die ferner ein oder mehrere Passelemente (O) umfasst, die in zentraler Position auf dem Basisflansch (5B) angeordnet sind und dazu geeignet sind, während der Installation eine Gehäuseführung für die Paneele (1) zu bilden.

6. Schnellverschlussvorrichtung (B) nach Anspruch 5, wobei das eine oder die mehreren Passelemente (O) durch einen Teil des Basisflansches (5B), der teilweise abgeschnitten und nach oben gefaltet ist, ausgebildet sind.

7. Die Schnellverschlussvorrichtung (B) nach einem der Ansprüche 1 bis 6, ferner umfassend mindestens ein gegenseitiges Eingriffselement (P), das geeignet ist, mit einem jeweiligen Schlitz (A), der auf dem Photovoltaik-Paneel (1) ausgebildet ist, während der Installation zusammenzuwirken.

8. Schnellverschlussvorrichtung (B) nach Anspruch 7, wobei das mindestens eine gegenseitige Eingriffselement (P) mittels eines Abschnitts des Basisflansches (5B) ausgebildet ist, der teilweise geschnitten und nach oben gefaltet ist.

## Revendications

1. Dispositif de verrouillage rapide (B) pour raccorder au moins un panneau solaire photovoltaïque (1) à une structure de support (S), le dispositif étant configuré de sorte que ledit au moins un panneau solaire photovoltaïque (1) peut être installé sur la structure de support (S) en l'approchant de ladite structure de support (S) avec un mouvement d'abaissement depuis le dessus uniquement selon une trajectoire rectiligne orthogonale à un plan de support dudit panneau solaire photovoltaïque (1) défini par ledit dispositif de verrouillage (B) jusqu'à atteindre une position définitive dans laquelle ledit dispositif de verrouillage (B) bloque automatiquement le panneau solaire photovoltaïque (1) sur la structure de support (S), le dispositif de verrouillage rapide (B) comprenant au moins un élément de blocage (B1) configuré pour pouvoir se décaler automatiquement pendant l'installation d'une position non opérationnelle libérée à une position opérationnelle de blocage après la mise en prise sur ce dernier par ledit panneau solaire photovoltaïque (1), lorsque le panneau solaire photovoltaïque (1) atteint sa position définitive,
dans lequel le dispositif de verrouillage rapide (B) comprend un étrier (5) ayant une bride de base (5B) ayant des moyens de fixation (H) pour la fixation à la structure de support (S), ladite bride de base (5B) ayant deux extrémités opposées pliées (5C), se terminant par des brides de renforcement (50) respectives pour former deux sièges en vis-à-vis sensiblement en forme de « C »,
le dispositif étant **caractérisé en ce qu'**il comprend :
deux éléments de blocage (B1), un à chaque extrémité, chaque élément de blocage (B1) comprenant un élément élastique en forme de feuille (70, 71) respectif formé pour être placé dans lesdits sièges en forme de « C » et ayant une partie de borne (71) faisant au moins partiellement saillie de ladite bride de renforcement (50).

2. Dispositif de verrouillage rapide (B) selon la revendication 1, comprenant en outre des éléments à mise en prise mutuelle (P), configurés pour coopérer pendant l'installation avec des éléments de mise en prise (A) correspondants du panneau solaire photovoltaïque (1) pour centrer le panneau solaire photovoltaïque (1) sur la structure de support (S).

3. Dispositif de verrouillage rapide (B) selon la revendication 2, dans lequel lesdits éléments à mise en prise mutuelle comprennent une broche de référence (P), et lesdits éléments de mise en prise (A) du panneau (1) comprennent une ouverture (A), de sorte que ladite broche de référence (P) peut être reçue dans ladite ouverture (A) dans la position définitive du panneau solaire photovoltaïque (1) sur la structure de support (S).

4. Dispositif de verrouillage rapide (B) selon l'une des revendications 1 à 3, dans lequel ladite bride de base (5B) comprend deux fentes (A1) mises en œuvre au niveau desdites parties de borne (71) pour permettre son abaissement pendant la mise en prise avec le panneau solaire photovoltaïque (1).

5. Dispositif de verrouillage rapide (B) selon l'une des revendications 1 à 4, comprenant en outre un ou plusieurs éléments correspondants (O) agencés dans la position centrale sur ladite bride de base (5B), aptes à fournir un guide de logement pour les panneaux (1) pendant l'installation.

6. Dispositif de verrouillage rapide (B) selon la revendication 5, dans lequel lesdits un ou plusieurs éléments correspondants (O) sont mis en œuvre au moyen d'une partie de la bride de base (5B) partiellement coupée et pliée vers le haut.

7. Dispositif de verrouillage rapide (B) selon l'une des revendications 1 à 6, comprenant en outre au moins un élément à mise en prise mutuelle (P), apte à coopérer avec une fente (A) respective mise en œuvre sur le panneau photovoltaïque (1) pendant l'installation.

8. Dispositif de verrouillage rapide (B) selon la revendication 7, dans lequel ledit au moins un élément à mise en prise mutuelle (P) est mis en œuvre au moyen d'une partie de bride de base (5B) partiellement coupée et pliée vers le haut.
